# EUROPEAN PATENT SPECIFICATION

(11) **EP 0 645 689 B1**
(45) Date of publication and mention of the grant of the patent: **05.04.2000**
(21) Application number: 94111067.8
(22) Date of filing: 15.07.1994
(51) Int. Cl.: G06F 1/08, G06F 1/30

(54) **Clock supply system**
Taktversorgunsystem
Système pour fournir un signal d'horloge

(30) Priority: 29.09.1993 JP 24279093; 18.10.1993 JP 26017393; 24.01.1994 JP 592694
(43) Date of publication of application: 29.03.1995
(73) Proprietor: SEIKO EPSON CORPORATION, Shinjuku-ku, Tokyo 163-0811 (JP)
(72) Inventor: Ichinose, Kazushige, Suwa-shi, Nagano-ken, 392 (JP); Kikushima, Masayuki, Suwa-shi, Nagano-ken, 392 (JP); Shirotori, Tooru, Suwa-shi, Nagano-ken, 392 (JP); Shigemori, Mikio, Suwa-shi, Nagano-ken, 392 (JP); Karasawa, Hideo, c/o Seiko Epson Corporation, Suwa-shi, Nagano-ken, 392 (JP)
(74) Representative: Hoffmann, Eckart, Dipl.-Ing.

(56) References cited:
- DE-A- 3 636 852
- DE-A- 4 022 887
- US-A- 3 855 484
- US-A- 5 095 280
- PATENT ABSTRACTS OF JAPAN vol. 016 no. 418 (P-1413) ,3 September 1992 & JP-A-04 140812 (HITACHI LTD) 14 May 1992,

## Description

The present invention relates to a clock supply system for electronic devices, e.g. computers, that require a variety of operating clock signals of different frequencies.

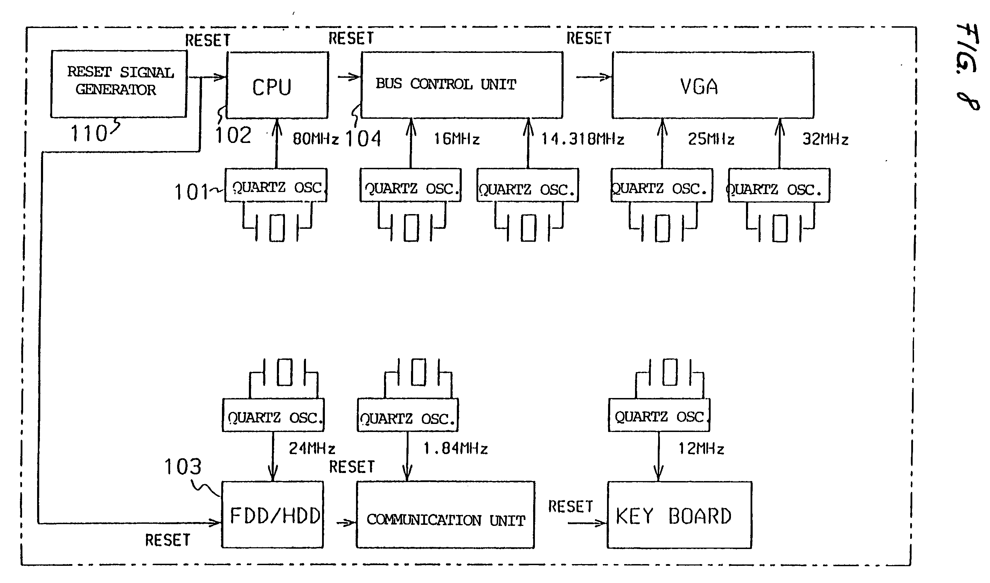

Fig. 8 shows one type of a conventional clock supply system for a computer. The computer shown in Fig. 8 comprises several units like a CPU unit 102, an FDD (floppy disk drive)/HDD (hard disk drive) unit 103, a bus control unit 104, a VGA (video graphics array) unit, a keyboard unit and others. A plurality of quartz oscillators 101 are provided, i.e. each unit has at least one quartz oscillator for its own to receive the required operating clock signal or signals. In this prior art, each quartz oscillator includes a CMOS-type IC chip and a quartz resonator. This imposes considerable cost and size limitations on products using this system. Further, at least some of the individual quartz oscillators have to generate high frequency operating clock signals. They require AT-cut quartz resonators which are expensive, especially in the high frequency range from 40 MHz to 80 MHz.

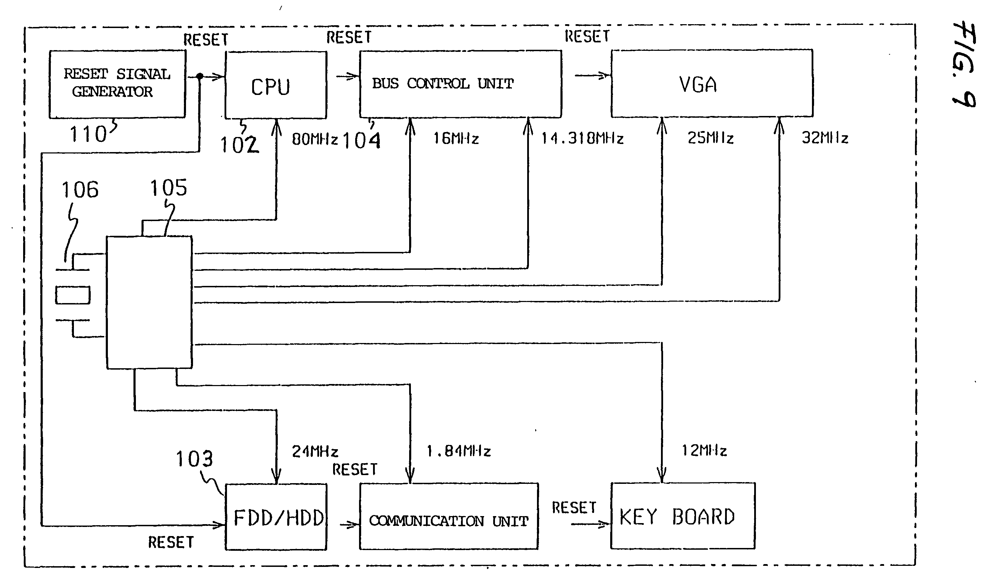

Fig. 9 shows another type of a conventional clock supply system used in a computer. Except for the clock supply system, the computer shown in Fig. 9 has the same structure as that of Fig. 8 and the same reference numerals are used to denote the same units. In the clock supply system of Fig. 9 a multi-output clock generator 105 is used to generate the various operating clock signals required for the individual units of the computer. Clock generator 105 comprises a quartz oscillator having a quartz resonator 106, and several PLL (phase locked loop) circuits each of which provides one of the required operating clock signals of different frequencies. The clock generator 105 supplies the individual operating clock signals to the respective units of the computer. Clock supply systems of this scheme have become widespread. In this clock supply system, however, clock lines are necessary to supply the operating clock signals from the common clock generator 105 to the individual units and at least some of these lines may extend over a substantial distance. Because of the high frequencies of the operating clock signals transmitted via these clock lines, EMI (electromagnetic interference) noise is generated which propagates over the whole circuit board forming the computer system and possibly even to the outside of the computer. This noise causes phase-shifted clocks and impulse clocks to enter the phase comparators of the PLL circuits included in the clock generator 105. This in turn degrades the purity (the C (carrier)/N (noise) ratio) of signals that are output from the voltage controlled oscillator contained in each PLL circuit. It also causes waveform fluctuations known as phase jitter. Another problem is that PLL circuits may become unlocked.

US-A-5,095,280 discloses a clock signal generator including a crystal oscillator circuit using a crystal resonator as a frequency reference. DE-A-36 36 852 discloses a reset circuit for applying reset signals to a microcomputer. To avoid a reset signal being applied in response to a voltage drop so short that the microcomputer does not realize it, the reset signals is generated by a timer. The timer operates whenever the supply voltage has a sufficient level. When the microcomputer is operating it periodically resets the timer thereby preventing reset pulses to be output by the timer. If due to a longer voltage drop the microcomputer is not operating it does not reset the timer so that after a certain time delay after the voltage has recovered the timer will output a reset pulse to reset the microcomputer.

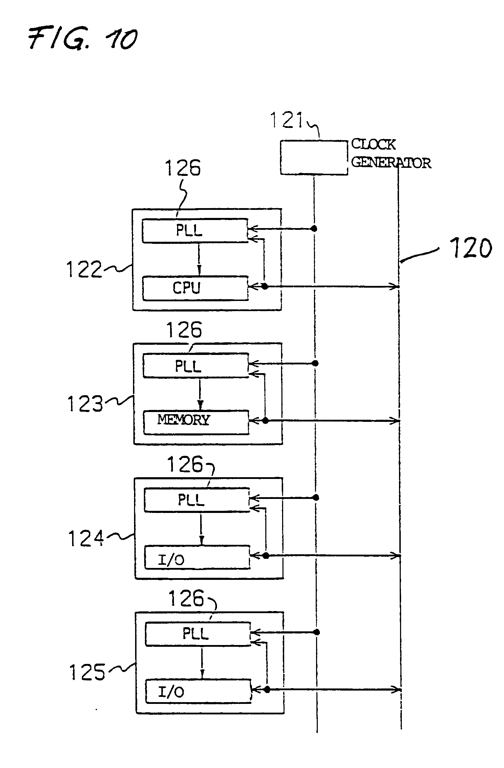

JP-A-4-140812 discloses a clock supply system which is shown in Fig. 10 and corresponds to the prior art portion of claim 1. 122, 123, 124 and 125 in Fig. 10 are semiconductor ICs that make up a computer for instance and that are connected with each other via a bus 120. In this prior art each of the ICs 122 to 125 contains its own PLL circuit 126 which are centrally supplied with a base clock from a clock generator 121. In this prior art, since the PLL circuits form an integral part of the individual semiconductor ICs, the frequency of the operating clocks for the CPU, memory, I/O controllers etc. of the computer is fixed. Every change in the operating frequency requires creation of a new semiconductor IC. Further, because the PLL circuits are formed inside each semiconductor IC, the operating clock generated by such a PLL circuit can be used within the IC only, that contains the PLL circuit. Furthermore, at higher frequency operating clocks, the heat generation in the PLL circuits poses a significant problem which requires heat dissipation measures for the respective ICs to be adapted to the additional heat generated by the PLL circuit. This in turn increases the costs.

As shown in Fig. 8 and 10, the conventional systems require a separate reset signal generator to ensure that the timing of the generation of reset signals matches the timing of the entire system. This requires complex and expensive timing adjustments for the reset signal generator.

It is an object of the present invention to solve the above problems inherent in the prior art and to provide a clock supply system that does not require a plurality of individual quartz oscillators, outputs and distributes operating clock signals of high signal purity and provides for a high flexibility as regards the change of operating frequencies.

This object is achieved with a clock supply system as claimed in claim 1.

Preferred embodiments of the invention are subject matter of the dependent claims.

According to the present invention, a common low frequency base clock signal is output from either a real-time clock module or a clock generator to the entire system of an electronic device, for instance a computer including a CPU unit, FDD/HDD unit, bus control unit and VGA unit, in a stable manner. This permits the start up of the entire electronic device/computer in a stable, accurate manner.

Further, because the required base clock signal is a low-frequency (e.g., 32.768 KHz) signal, even in cases where the length of interconnections on the circuit board is increased, the amount of EMI radiation noise remains extremely low both inside and outside of the electronic device. This ensures a stable supply of operating clock signals. The extremely low level of electromagnetic radiation to the outside keeps noise insulation measures simple, and this facilitates efforts to achieve size reductions in , for instance, a computer.

As a further advantage, only one piezoelectric resonator for the entire system is required, and this resonator can be an inexpensive, low-frequency resonator (e.g., 32.768 KHz). This reduces the overall cost of the system, reduces the packing density of circuit board and other components, and thus enhances the flexibility in mount layout.

Further, all frequency synthesizers containing PLL circuits and used for the purposes of the present invention can use common IC chips. Those IC chips can be small and inexpensive. Also, the frequency synthesizers containing PLL circuits can be controlled from outside on a common basis. This enhances the general applicability and greatly simplifies the configuration of the system incorporating these frequency synthesizers. The frequency synthesizer is positioned so that the length of the signal line from the frequency synthesizer to the unit (CPU, etc) is shorter than that of the signal line from the low-frequency clock generator to the frequency synthesizer.

According to the invention, the base clock signal that is input into the PLL circuits can be of a low-frequency variety (e.g., 32.768 KHz). Compared to conventional oscillator circuits that output clock signals in the 10 MHz range, this reduces the oscillation power consumption approximately in proportion to the required frequency. This results in an extremely low power consumption, and helps to reduce the electric consumption of the entire system. Further, the reduced power consumption during oscillation reduces the amount of heat generation in the IC chip. This permits the provision of PLL circuit-containing frequency synthesizers and systems of high reliability.

Further, by designing the drive voltage for the PLL circuit in the 3V - 5V range, instead of relying on the voltage of the output line for the base clock signal, frequency synthesizers containing PLL circuits using the same components can use the drive voltages provided for operation of various units of the electronic device. Compared with the conventional piezoelectric oscillator that required the creation of a new IC chip for each drive voltage, this significantly reduces the system's delivery lead-time and developmental costs. Thus, this easily accommodates the systems that contain both 3V and 5V devices.

Also, because the I/O pins for frequency synthesizers containing PLL circuits can all be common, circuit board interconnections for different units can be provided on a common basis. This substantially reduces the amount of required design work.

The frequency synthesizers containing PLL circuits according to the present invention can be fabricated as standard components. Compared with conventional piezoelectric oscillators and multioutput clock generators that can be manufactured only after the desired output frequency is determined, the new frequency synthesizers substantially reduce fabrication lead-time.

Whereas in conventional multi-output clock generators a single difference in the system's frequency requires a change in the IC chips for the generator, the frequency synthesizers containing PLL circuits of this invention are capable of producing either 8 or 16 frequencies for each of the electronic device units. This enhances the general applicability and flexibility in system design. If any other frequencies are needed, frequencies for any operating clock signal can be obtained by modifying the masks for the AI interconnections for the IC chip.

Further, because the frequency synthesizer containing PLL circuits do not need to contain a built-in piezoelectric resonator, a further reduction in the size and thickness of the frequency synthesizer is possible.

Ordinary computers employ a 32.768 kHz clock for refreshing the image memory in a stand-by state. Where, according to the preferred embodiment of the present invention, 32.768 kHz is used as the frequency of the base clock signal, the base clock signal can be input directly into a VGA unit for this purpose and no separate oscillator or other means for generating such 32.768 kHz clock is required. This permits a further cost reduction.

By using the clock supply system according to the invention, it is possible to achieve cost reductions, power reductions, and down-sizing in computers and electronic devices that require multiple operating clock signals.

According to an embodiment of the invention, in cases where reset signals for, for instance, a CPU are required, by employing a delay circuit for generating a reset signal after a certain delay time from the power-up time during the startup of the entire system, it is possible to achieve accurate, reliable system startup for high-speed operations.

Further, in an embodiment of the invention where the base clock signal is supplied to the entire system as a low-frequency signal and only during operation of the electronic device, there is a reduction in power consumption, and this prolongs the life time of a back-up battery. This is because the signal line transmitting a base clock signal inevitably has a capacitance, and the power of the back-up battery is consumed by the capacitance.

Embodiments of the present invention will be explained in detail below with reference to the drawings, in which:
- Fig. 1: is a block diagram of a computer employing a first embodiment of the clock supply system according to the present invention,
- Fig. 2: is a block diagram of a computer illustrating another embodiment of the present invention,
- Fig. 3: is a functional block diagram showing a frequency synthesizer containing a PLL circuit, used in the present invention,
- Fig. 4: is a functional block diagram showing another embodiment of a frequency synthesizer containing a PLL circuit used in the present invention,
- Fig. 5: is a structural diagram showing an embodiment of a frequency synthesizer containing a PLL circuit used in the present invention,
- Fig. 6: is an output frequency table for explaining an embodiment of a frequency synthesizer used in the present invention,
- Fig. 7: is a structural diagram showing another embodiment of a frequency synthesizer containing a PLL circuit used in the present invention,
- Fig. 8: is block diagram illustrating a prior art clock supply system,
- Fig. 9: is a block diagram illustrating another prior art clock supply system, and
- Fig. 10: is a block diagram illustrating still another prior art clock supply system.

In the following various embodiments of the present invention will be explained with reference to a computer as the electronic device to be supplied with various operating clock signals of different frequencies. It should be understood, however, that a computer is taken as a example only and that the present invention may be applied to other electronic devices having similar demands, as well.

A clock supply system according to the present invention employs a clock generator module or a clock generator forming part of a real-time clock module. In each case the dock generator includes an oscillator circuit which employs a quartz resonator as a frequency normal. For the purpose of the present invention a real-time clock module refers to a module that keeps time and/or calendar information necessary for the operation of computers or similar electronic devices. In the present invention, the clock signal generated by the clock generator is provided as a base clock signal to each of plural frequency synthesizers each containing at least one PLL circuit and each being separate from but associated with one or more units of the electronic device, i.e. the computer in the following embodiments.

The frequency of the base clock signal from the clock generator is set to be less than or equal to a system frequency required by the electronic device in which the clock supply system is used. Preferably, this frequency is a few MHz, or even less than 100 kHz. The reason for this restriction is that a frequency exceeding this range increases the amount of current consumed by the system. Another reason is that, since this base clock signal has to be supplied to plural frequency synthesizers, even if the distance between the clock generator and a respective frequency synthesizer on the circuit board is relatively long, because of the low frequency of the clock signal no EMI noise will be caused. In the embodiments explained below a base clock frequency of 32.768 kHz is employed which is a widely used clock frequency for measuring time and calendar information.

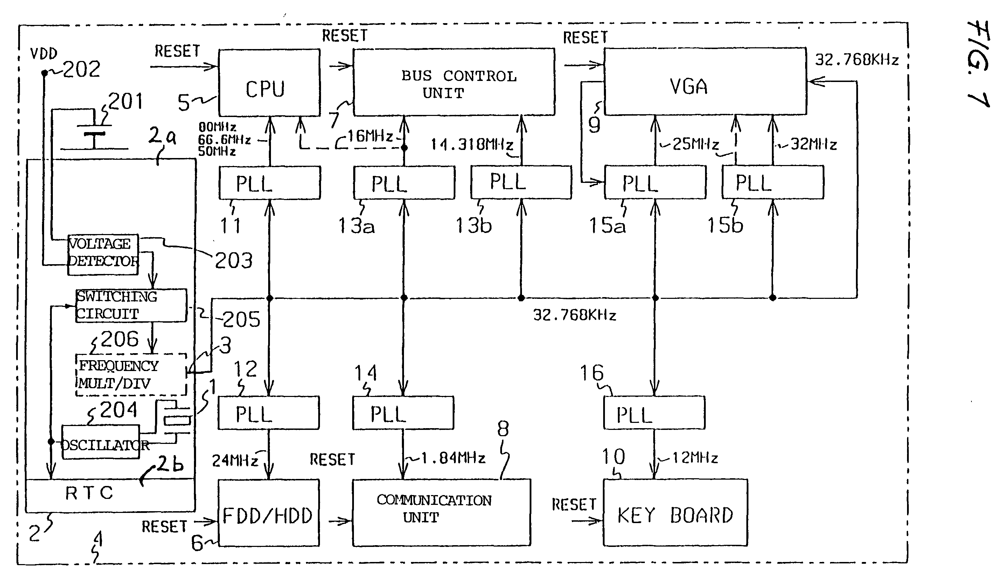

Referring to Fig. 1 there is shown a block diagram of a computer 4 illustrating a first embodiment of the clock supply system according to the present invention. Fig. 1 also shows one embodiment of a real-time clock module.

The computer comprises a CPU unit 5, an FDD/HDD unit 6, a bus control unit 7, a communication unit 8, a VGA unit 9 and a keyboard unit 10. The real-time module 2 is comprised of a clock generator section 2a and an RTC section 2b. The RTC section 2b is a circuit that measures time and/or calendar information based on a clock signal produced by the clock generator section 2a. A base clock signal output from an output terminal 3 of the clock generator section 2a is supplied via a corresponding wiring on the circuit board mounting the individual units of the computer 4 to each of a plurality of frequency synthesizers 11, 12, 13a, 13b, 14, 15a, 15b and 16. Each frequency synthesizer includes at least one PLL circuit (therefore, they are denoted "PLL" in the figure). In this embodiment, the base clock signal is a 32.768 kHz clock generated by means of a built-in quartz resonator 1 that oscillates at the frequency of 32.768 kHz which, as mentioned above, is the frequency commonly used for clocks. As shown in Fig. 1, the frequency synthesizers 11, 12, 13a, 13b, 14, 15a, 15b and 16 are connected to CPU unit 5, the FDD/HDD unit 6, the bus control unit 7, the communication unit 8, the VGA unit 9 and the keyboard unit 10, respectively. The frequency of the base clock signal input into the frequency synthesizers is multiplied by them to obtain operating clock signals of the frequencies required by and supplied to the respective units forming the computer 4. For example, the frequencies required for the CPU unit 5 are 80 MHz, 66.6 MHz and 50 MHz. These frequencies are produced and output by frequency synthesizer 11. Similarly, the frequency required for the FDD/HDD unit 6 is 24 MHz, which is produced and output by frequency synthesizer 12. The frequencies required for the bus control unit 7 are 16 MHz and 14.318 MHz, which are produced and output by frequency synthesizers 13a and 13b. The frequencies required for the communication unit 8, the VGA unit 9 and keyboard unit 10 are produced and output by frequency synthesizers 14, 15a, 15b and 16.

Thus, the 32.768 kHz base clock signal is frequency-converted to the 1.843 MHz - 80 MHz range by the frequency synthesizers. The 32.768 kHz clock frequency of the quartz resonator 1 is also utilized as a reference clock signal for the VGA unit 9 and other components.

Although in the present embodiment the quartz resonator 1 is built into the real-time clock module 2, the quartz resonator 1 may also be a separate component mounted externally and connected to the real-time clock module 2.

The clock generator section 2a of the real-time clock module 2 is composed of: a voltage detector circuit 203, an oscillator circuit 204, a switching circuit 205 and, if required, a frequency multiplier/divider circuit 206. Circuit 206 (shown in dotted lines in the figure) may be provided to either divide or multiply the oscillation frequency generated by the oscillator circuit 204 if this frequency differs from the one desired for the base clock signal. Circuit 206 may also be provided simply as a buffer amplifier. The oscillator circuit 204 oscillates the quartz resonator 1 connected to it. The voltage detector circuit 203 is connected to both, a main power source VDD 202 and a back-up battery 201, and compares the voltages applied by these two power sources. Depending on an output signal from the voltage detector circuit 203, the switching circuit 205 either supplies or interrupts the output signal from oscillator circuit 204 to output terminal 3 or, if provided, the frequency multiplier/divider circuit 206.

In order to maintain its time and/or calendar keeping function, the real-time clock module 2 must be continuously powered and supplied with the accurate frequency signal from the oscillator circuit 204. For this reason the real-time clock module 2, at least the oscillator circuit 204 and the RTC section 2b are backed-up by means of the back-up battery 201. During back-up operation the base clock signal is not supplied to any of the frequency synthesizers 11 through 16 in order to conserve the power of the battery 201. This function is achieved by means of the switching circuit 205 controlled by the voltage detector circuit 203 when the latter detects that the battery voltage is higher than the voltage of the main power supply 202. Therefore, during the back-up operation the power consumption of the real-time clock module 2 remains extremely low with a current flow of only 0.3 to 0.4 µA. When the main power source 202 for the CPU unit 5 and the other units of the computer 4 is turned on, its voltage rises from zero to a required level. When the voltage of the main power source 202 becomes equal to or exceeds the voltage of the battery 201 or a predetermined voltage, the voltage detector circuit 203 outputs a control signal to activate the switching circuit 205. As a result, the clock signal output from the oscillator 204 is supplied as a base clock signal to the circuit board through the output terminal 3. The predetermined voltage is set by a zener diode. It may also be set by a battery voltage multiplied by a constant value.

As shown in Fig. 1, an operating clock signal output from any of the frequency synthesizers can be applied to one or more units of the computer, as required. In the embodiment shown in Fig. 1 it is possible, for instance, to output a common 16 MHz frequency operating clock signal from frequency synthesizer 13a to the bus control unit 7 and CPU unit 5. Likewise, it is possible to output plural operating clock signals of different frequencies from one frequency synthesizer, for example a 32 MHz signal and a 25 MHz signal from frequency synthesizer 15b. Frequency synthesizers that contain plural PLL circuits are able to output several frequencies, one output frequency per PLL circuit. Depending on the required operating frequencies, a frequency synthesizer may also include one or more frequency dividers to generate operating frequencies by dividing the output frequency of a PLL circuit. By commonly providing one or more operating clock signals from one frequency synthesizer to plural units each frequency synthesizer needs only to have a minimum number of PLL circuits and/or frequency dividers thereby contributing to cost and size reduction.

According to the above configuration, a base clock signal of a low frequency generated by a single quartz oscillator is supplied to the entire computer system and only during computer operation. The result is a low power consumption. Further, because adjacent units of the computer can commonly use an operating clock signal generated by one of the frequency synthesizers, the configuration allows the total number of frequency synthesizers to be reduced to a minimum. This feature permits considerable system size and cost reductions. As indicated in Fig. 1, each frequency synthesizer can be and preferably is arranged on the circuit board in the vicinity of the unit or units it is to supply with operating clock signals. Thus, only short operating clock signal transmission lines are required for connection between the frequency synthesizers and the units of the computer and it is only the base clock signal having a relatively low frequency which may need to be transmitted through a longer distribution wire on the circuit board. As a result of this configuration, the prior art problem of EMI noise does not occur.

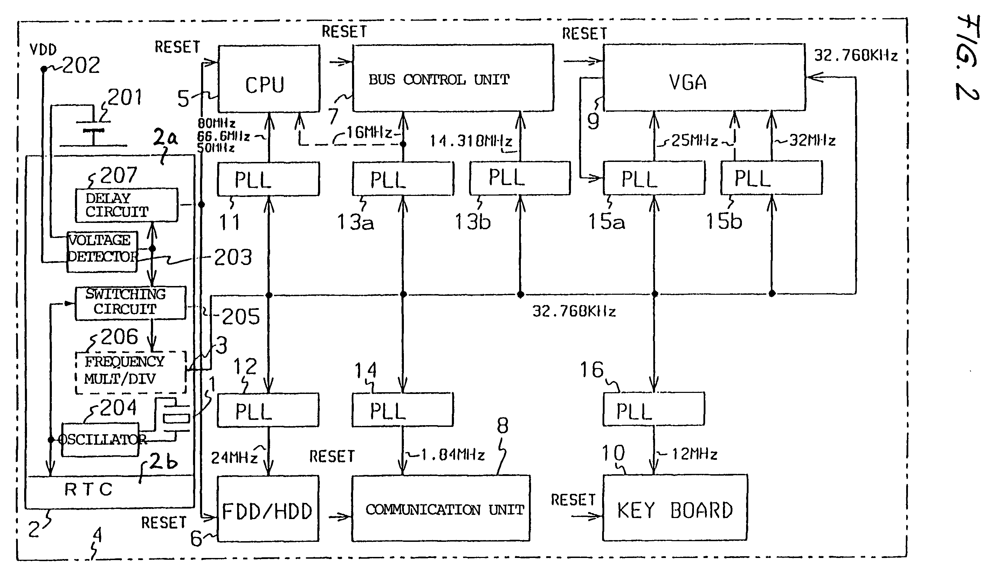

Fig. 2 shows a second embodiment of the invention. The following description of this second embodiment will be restricted to the differences between the first and the second embodiment. In the second embodiment, the real-time clock unit 2 additionally includes a reset signal generator comprising a delay circuit 207 which is employed to provide a reset signal to all of the units 5 to 10 that require resetting by a RESET signal. This RESET signal is output after the operating clock signals generated by the frequency synthesizers 11 to 16 have become stable. To achieve this purpose, the delay circuit 207 is triggered by the rising edge of the output signal from the voltage detector circuit 203, which is produced under the same condition as in the first embodiment. The delay circuit 207 outputs the RESET signal when a preset delay time has passed after the delay circuit 207 was triggered by the output from the voltage detector circuit. Delay time measurement can be made very accurate by counting a corresponding number of pulses of the highly frequency-constant clock signal obtained from the oscillator circuit 204. This can be also made by using a CR oscillator.

The above described configuration of the second embodiment of the invention permits an accurate control of the timing of the RESET signal relative to the time the power is turned on during system start up. This permits an accurate, high-speed system start up.

The first and second embodiments have been described as using a real-time clock module IC 2 for generating the base clock signal and at the same time for keeping time and/or calendar information. Where a real-time clock function for keeping time and/or calendar information is not required, each of these two embodiments can be modified by employing a clock generator module corresponding in structure and function to the clock generator section 2a, instead of real-time clock module 2,.

These modified embodiments provide the same advantages as regards the clock supply, such as the use of a single, low-cost, low-frequency quartz resonator (for instance of a 32.768 kHz frequency), a reduction of the overall cost of the system and a decrease of the density of components that are mounted on the circuit board. The result is an increased flexibility in mount layout.

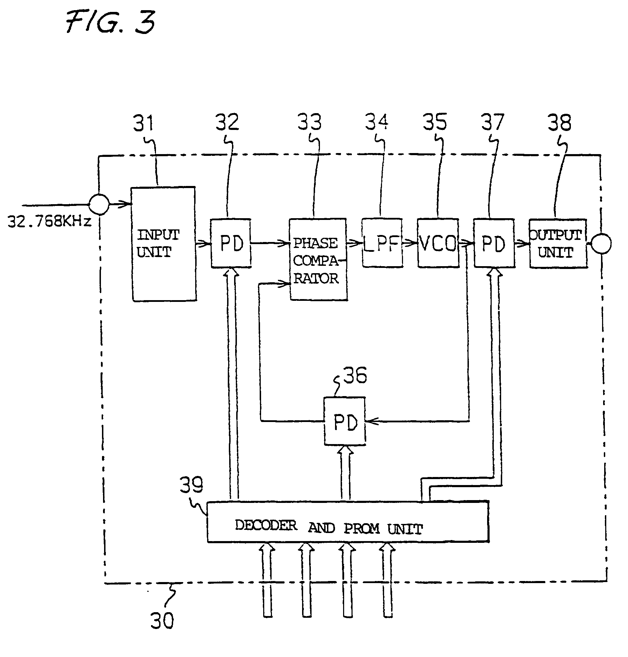

Fig. 3 is a functional block diagram showing an embodiment of a frequency synthesizer suitable for any of the embodiments of the invention described above. In the frequency synthesizer shown in Fig. 3, the 32.768 kHz base clock signal is input into a clock input unit 31 as an input buffer which serves to shift a voltage level or suppress noise. The output from this unit is supplied to a first programmable frequency divider (hereinafter referred to as "PD") 32. The frequency divided output from PD 32 is applied to one input of a phase comparator 33 which, together with a low-pass filter 34, a voltage controlled oscillator VCO 35, and a second PD 36 forms a PLL circuit as is well known to those skilled in the art. The output from the VCO 35, i.e. the output from the PLL circuit, is supplied to a third PD 37 whose output in turn is supplied to an output terminal of the frequency synthesizer via an output unit 38 as an output buffer.

The first PD 32 frequency divides the output from the clock input unit 31 by a predetermined division factor. The phase comparator 33 generates a control voltage corresponding to the phase difference between the input signals applied to its two input terminals, namely the output signal from PD 32 and that from PD 36. The low-pass filter 34 removes high-frequency components from the output from the phase comparator 33. The VCO 35 generates an output signal whose frequency is controlled by the control voltage from the phase comparator 33. The second PD 36 frequency divides the output from the VCO 35 by a specified division factor and supplies the divided signal as the second input signal to the phase comparator 33.

The embodiment shown in Fig. 3 additionally includes a PROM and decoder unit 39 whose decoder part is connected to external control input terminals . In response to frequency setting signals applied to the external control input terminals the unit 39 controls the operation of the first, second and third PDs 32, 36 and 37 by setting the respective division factors, in order to select and vary the output frequency from the output unit 38. The frequency setting signals are decoded by the decoder part of the unit 39, and the decoded output is used to read the division factors from the PROM part of unit 39. The general structure and the way of programming the PROM part of unit 39 are well known to those skilled in the art and, thus, will not be explained here. It is to be noted that a PROM as part of the unit 39 is mentioned as an example only and that other types of ROM including a Fuse ROM can be used instead to provide the desired setting of the division factors depending on frequency setting signals.

The above configuration permits the input of frequency-setting signals from an external source and allows all frequency synthesizers to be constructed by using the same types of common IC chips.

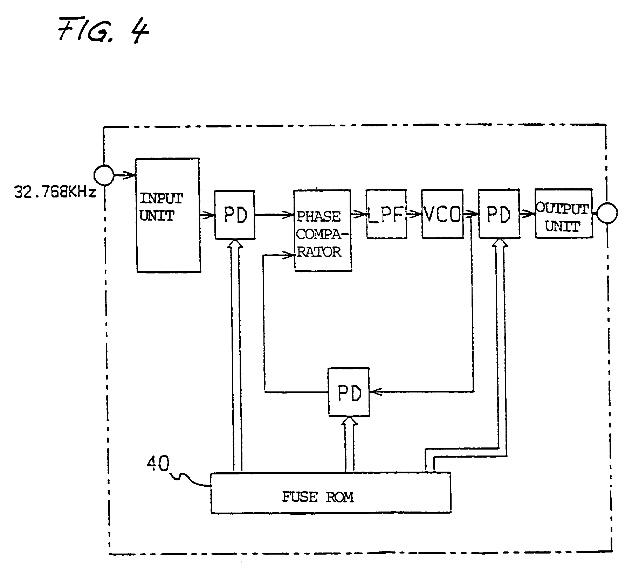

Fig. 4 is a functional block diagram showing another embodiment of a frequency synthesizer for the clock supply system according to the invention. This embodiment differs from that of Fig. 3 only in that the unit 39 of Fig. 3 is replaced by a Fuse ROM unit 40. As is well known, the term "Fuse ROM" refers to a ROM which includes fuses and which is programmed by selectively melting and cutting desired ones of the fuses. This programming is performed by laser beam irradiation of the IC chip including the Fuse ROM or by means of an electric current. In this embodiment the Fuse ROM is not combined with a decoder and no control input terminals are required. Instead, the unit 40 supplies a respective predetermined and fixed division factor to each of the first, second and third PDs 32, 36 and 37.

In the above described configuration of Fig. 4, since the output frequency is predefined by the programming of the Fuse ROM and fixed, no external control input terminals are needed. This permits the use of the same circuit board interconnection for different units. The result is a substantial reduction in the amount of design work that is required. The simplicity of output frequency determination reduces the costs of the frequency synthesizer.

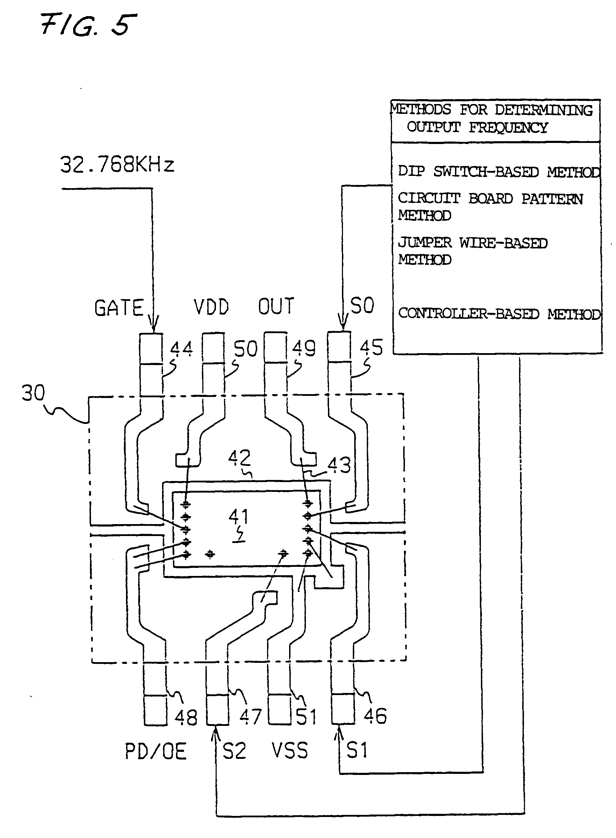

Fig. 5 is a structural diagram showing an embodiment of a frequency synthesizer for the clock supply system according to the present invention. A PLL IC chip 41 containing the functional block shown in Fig. 3, is mounted on an island 42. The pads of the PLL IC chip 41 and the lead terminals surrounding the island 42 are wired using Au wires 43. The above components are molded using resin mold materials.

The frequency synthesizer 30 shown in Fig. 5 has the following I/O terminals: a gate terminal 44 which receives the 32.768 kHz base clock signal; an S0 terminal 45, an S1 terminal 46, an S2 terminal 47 and a PD (power-down)/OE (output-enable) control terminal 48, which receive frequency-setting signals from external sources; an output terminal OUT 49 and supply voltage terminals VDD 50 and VSS 51.

Methods of producing frequency-setting signals to be applied to terminals 45, 46 and 47 include a DIP switch-based method, a circuit board pattern method, a jumper wire method and a controller-based control method. These methods will be explained in more detail below.

The DIP switch-based method involves selectively applying HIGH or LOW level (corresponding to "1" and "0") input signals by connecting a DIP switch to the terminals 45, 46 and 47. Separate switches instead of a DIP switch can also be employed.

The circuit board pattern method involves designing a circuit board pattern in advance in order to obtain the desired frequency by applying respective HIGH or LOW level frequency-setting signals to the terminals 45, 46 and 47.

The jumper wire-based method involves using so-called jumpers in order to selectively apply the frequency-setting signals to the terminals 45, 46 and 47. This method is similar to the DIP switch-based method except that jumpers are set or removed instead of operating a switch.

With the controller-based method HIGH and LOW level frequency setting signals are supplied to the external control terminals S0 to S2 (Fig. 5) from a controller (not shown) in the CPU unit 5 or the VGA unit 9.

A power-down function controlled via PD control terminal 48 is designed to achieve an overall reduction in the system's power consumption by halting the operation of the PLL IC chip 41. When the PD control terminal 48 is electrically at an "H" state, the PLL IC chip continues to run. When this state is changed to an "L" state, the chip's operation ceases and output halts. In the embodiment of Fig. 1, for instance, to power down the VGA unit 9, the PD control terminal 48 for either frequency synthesizer 15a or 15b is made electrically "L" by means of a control signal from the VGA unit 9. This halts the output of the 25 MHz and the 32 MHz operating clock signals.

The output enable function allows the selection of the state of the PLL IC chip 41 in terms of either an output state or a high impedance. When the OE control terminal 48 is electrically "H", for example, an operating clock signal is output from the chip. When the terminal is electrically "L" the output assumes a high impedance state. As in the case of the PD control terminal, the OE control terminal can be controlled by means of control signals from the various units.

In the above embodiment, both the power-down and output enable functions of the PLL IC chip 41 are wired to the same I/O terminal 48. In this case, both the power-down and output enable functions are controlled simultaneously. However, it is not necessary that the wiring be limited to this embodiment, i.e. the two functions may be wired and controlled independently.

The above configuration permits the input of frequency-setting signals from external sources, and this enhances the general applicability of the system. Also, it is possible to control the power-down and output enable functions for each frequency synthesizer.

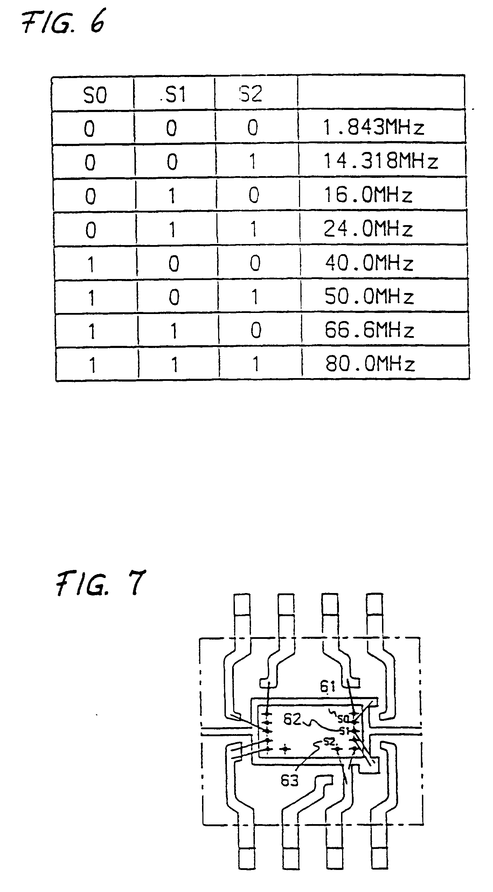

Fig. 6 shows an example of an output frequency table for the frequency synthesizer 30 (see Fig. 3 and 5). Assuming that the frequency-setting signal applied to each of the terminals S0, S1 and S2 in Fig. 5 is a binary signal of either "1" or "0", there will be eight possible combinations corresponding to eight frequency options like those shown in Fig. 6 as an example. By increasing the number of terminals adapted to receive frequency-setting signals to four, it is possible to provide 16 frequency options (a corresponding frequency table is not shown). The frequencies shown as example in Fig. 6 are those commonly used for computer operating clock signals.

As noted above, the above configuration permits the selection of a desired frequency from an output frequency table, thus enhancing the general applicability of the system. Also, by providing masks for Al interconnections that accommodate several output tables, it is possible to accommodate any frequency.

Fig. 7 is another embodiment of the structural configuration of a frequency synthesizer for the clock supply system of the present invention. In this embodiment, any pull-up or pull-down of the S0 terminal 61, S1 terminal 62 and S2 terminal 63 adapted to receive frequency-setting signals, is predetermined through the use of Au wire interconnection. Also in this case, the same or similar output frequencies as those shown in the table of Fig. 6 can be preselected. The configuration of this embodiment involves output frequencies that are fixed in advance. This allows the use of common circuit board wiring for different units, and substantially reduces the amount of design work that is required. This configuration also allows a compact implementation of frequency synthesizers that contain PLL circuits, and can facilitate the system size to be reduced.

## Claims

1. A clock supply system comprising a clock generator (2a) for generating a base clock signal, and a plurality of frequency synthesizers (11-16) commonly fed with said base clock signal for generating clock signals of various frequencies used to operate units (5-10) of an electronic computing device (4) wherein said clock generator has a piezoelectric resonator (1) that serves as a reference frequency source and an oscillator circuit (204) that oscillates in response to said piezoelectric resonator,
**characterized in that** said frequency synthesizers are provided separately from said units in a manner that allows their independent operation, and each frequency synthesizer is positioned so that the length of the signal line from said frequency synthesizer to said unit is shorter than that of the signal line from said clock generator to said frequency synthesizer.

2. The clock supply system of claim 1 further comprising:
a main power source (202), and
an auxiliary power source (201),
wherein said clock generator (2a) further comprises:
a voltage detector circuit (203) that compares the voltage of said auxiliary power source with the voltage of said main power source and outputs a control signal when the main power source voltage is equal to or exceeds the auxiliary power source voltage or a predetermined voltage of said voltage detector circuit, and
switching circuit means (205) responsive to said control signal for passing said base clock signal to said frequency synthesizers (11-16).

3. The clock supply system of claim 2, characterized in that said clock generator further comprises a reset signal generating means (207) responsive to said control signal for generating a reset signal after passage of a predetermined delay time after the moment the voltage of said main power source becomes equal to or exceeds said auxiliary power source voltage or said predetermined voltage.

4. The clock supply system according to any one of the preceding claims characterized in that said clock generator is part of a real-time clock module IC (2) further including means (2b) for keeping time and/or calendar information.

5. The clock supply system according to any one of the preceding claims, characterized by a plurality of said frequency synthesizers (11-16) each containing one or more PLL circuits to simultaneously produce one or more frequencies.

6. The clock supply system according to claim 5 characterized by said frequency synthesizers further having dividing means (37, 39, 40) for frequency dividing the output signal of the voltage controlled oscillator of each PLL circuit (33-36) and control terminals for controlling said dividing means such that specified frequencies are output by means of electrical processing performed on said control terminals.

7. The clock supply system according to claim 6, characterized in that, said dividing means (37, 39, 40) comprises a memory device (39, 40), wherein specified frequencies are obtainable by writing data to said memory device by means of electric processing on said control terminals, and by means of data control using the data written into said memory device.

8. The clock supply system according to claim 5, characterized in that, said dividing means comprises various combinations of electrical connections to external control terminals.

9. The clock supply system according to any one of the preceding claims wherein said electronic device is a computer and said units include at least one of a CPU unit (5), an FDD/HDD unit(6), a bus control unit (7), a communication unit (8), a VGA unit (9) and a keyboard unit (10), each including a semiconductor IC unit.

10. The clock supply system according to claim 9, characterized in that at least one clock signal from at least one of said frequency synthesizers (13a) is commonly supplied to at least two of said units (5, 7).

## Patentansprüche

1. Taktversorgungssystem mit einem Taktgenerator (2a) zum Erzeugen eines Grundtaktsignals sowie einer Vielzahl von Normalfrequenzgeneratoren (11-16), denen gemeinsam das Grundtaktsignal zugeführt wird, um Taktsignale unterschiedlicher Frequenzen für den Betrieb von Einheiten (5-10) einer elektronischen Rechenvorrichtung (4) zu erzeugen, bei der der Taktgenerator einen piezoelektrischen Schwinger (1), der als Quelle einer Bezugsfrequenz dient, und einen Oszillatorschaltkreis (204) umfaßt, der in Abhängigkeit von dem piezoelektrischen Schwinger schwingt, dadurch gekennzeichnet, daß die Normalfrequenzgeneratoren getrennt von den Einheiten derartig vorgesehen sind, daß sie unabhängig betrieben werden können, und daß jeder Normalfrequenzgenerator so angeordnet ist, daß die Länge der Signalleitung vom Normalfrequenzgenerator zu der Einheit kürzer ist als die der Signalleitung vom Taktgenerator zum Normalfrequenzgenerator.

2. Taktversorgungssystem nach Anspruch 1 ferner mit:
einer Hauptspannungsquelle (202) und
einer Hilfsspannungsquelle (201),
wobei der Taktgenerator (2a) ferner folgendes aufweist:
einen Spannungsdetektorschaltkreis (203), der die Spannung der Hilfsspannungsquelle mit der Spannung der Hauptspannungsquelle vergleicht und ein Steuersignal ausgibt, wenn die Spannung der Hauptspannungsquelle derjenigen der Hilfsspannungsquelle oder einer vorherbestimmten Spannung des Spannungsdetektorschaltkreises gleicht oder diese übersteigt, und
eine Umschaltkreiseinrichtung (205), die auf das Steuersignal anspricht und das Grundtaktsignal an die Normalfrequenzgeneratoren (11-16) weiterleitet.

3. Taktversorgungssystem nach Anspruch 2, dadurch gekennzeichnet, daß der Taktgenerator ferner eine Rückstellsignalerzeugereinrichtung (207) aufweist, die auf das Steuersignal anspricht und ein Rückstellsignal erzeugt, wenn eine vorherbestimmte Verzögerungszeit nach dem Moment abgelaufen ist, an dem die Spannung der Hauptspannungsquelle derjenigen der Hilfsspannungsquelle oder der vorherbestimmten Spannung gleich wurde oder diese überschnritt.

4. Taktversorgungssystem nach einem der vorhergehenden Ansprüche, dadurch gekennzeichnet, daß der Taktgenerator Teil eines Echtzeit-Uhrmodul-ICs (2) ist, welches ferner eine Einrichtung (2b) zum Führen von Zeit- und/oder Kalenderinformationen umfaßt.

5. Taktversorgungssystem nach einem der vorhergehenden Ansprüche, gekennzeichnet durch eine Vielzahl von Normalfrequenzgeneratoren (11-16), die jeweils eine oder mehrere PLL-Schaltungen enthalten, um gleichzeitig eine oder mehrere Frequenzen zu erzeugen.

6. Taktversorgungssystem nach Anspruch 5, dadurch gekennzeichnet, daß die Normalfrequenzgeneratoren ferner eine Dividiereinrichtung (37, 39, 40) zur Frequenzteilung des Ausgangssignals des spannungsgesteuerten Oszillators jeder PLL-Schaltung (33-36) und Steueranschlüsse besitzen, mit denen die Dividiereinrichtung so gesteuert wird, daß mittels an den Steueranschlüssen vorgenommener elektrischer Verarbeitung spezifizierte Frequenzen ausgegeben werden.

7. Taktversorgungssystem nach Anspruch 6, dadurch gekennzeichnet, daß die Dividiereinrichtung (37, 39, 40) einen Speicherbaustein (39, 40) aufweist, wobei spezifizierte Frequenzen dadurch zu erhalten sind, daß Daten mittels elektrischer Verarbeitung an den Steueranschlüssen in den Speicherbaustein eingegeben werden und mit Hilfe einer Datensteuerung unter Verwendung der in den Speicherbaustein eingegebenen Daten.

8. Taktversorgungssystem nach Anspruch 5, dadurch gekennzeichnet, daß die Dividiereinrichtung verschiedene Kombinationen elektrischer Verbindungen mit externen Steueranschlüssen aufweist.

9. Taktversorgungssystem nach einem der vorhergehenden Ansprüche, bei dem das elektronische Gerät ein Rechner ist und die Einheiten mindestens eine der folgenden umfassen: eine CPU-Einheit (5), eine FDD/HDD-Einheit (6), eine Bussteuereinheit (7), eine Kommunikationseinheit (8), eine VGA-Einheit (9) und eine Tastatureinheit (10), die jeweils eine Halbleiter-IC-Einheit einschließen.

10. Taktversorgungssystem nach Anspruch 9, dadurch gekennzeichnet, daß mindestens ein Taktsignal von mindestens einem der Normalfrequenzgeneratoren (13a) mindestens zwei der Einheiten (5, 7) gemeinsam zugeführt wird.

## Revendications

1. Système de fourniture d'horloge comprenant un générateur (2a) d'horloge destiné à générer un signal d'horloge de base, et une pluralité de synthétiseurs (11-16) de fréquence recevant en commun le signal d'horloge de base pour générer des signaux d'horloge de diverses fréquences utilisés pour faire fonctionner des unités (5-10) d'un dispositif (4) de calcul électronique, le générateur d'horloge ayant un résonateur (1) piézoélectrique qui est utilisé comme source de fréquence de référence et un circuit (204) oscillateur qui oscille en réponse au résonateur piézoélectrique,
caractérisé en ce que les synthétiseurs de fréquence sont diposés séparément des unités d'une manière qui permet leur fonctionnement indépendant, et en ce que chaque synthétiseur de fréquence est positionné de façon que la longueur de la ligne de signal allant du synthétiseur de fréquence à l'unité en question soit plus courte que celle de la ligne de signal allant du générateur d'horloge au synthétiseur de fréquence.

2. Système de fourniture d'horloge suivant la revendication 1, comprenant en outre :
une source (202) d'alimentation principale, et
une source (201) d'alimentation auxiliaire,
le générateur (2a) d'horloge comprenant en outre :
un circuit (203) détecteur de tension qui compare la tension de la source d'alimentation auxiliaire à la tension de la source d'alimentation principale et délivre un signal de commande lorsque la tension de la source d'alimentation principale est égale ou supérieure à la tension de la source d'alimentation auxiliaire ou à une tension déterminée à l'avance du circuit détecteur de tension, et
un moyen (205) à circuit de commutation sensible au signal de commande pour laisser passer le signal d'horloge de base vers les synthétiseurs (11-16) de fréquence.

3. Système de fourniture d'horloge suivant la revendication 2, caractérisé en ce que le générateur d'horloge comprend en outre un moyen (207) générateur de signal de remise à zéro sensible pour générer un signal de remise à zéro après écoulement d'un temps de retard déterminé à l'avance après le moment où la tension de la source d'alimentation principale est devenue égale ou supérieure à la tension de la source d'alimentation auxiliaire ou à la tension déterminée à l'avance.

4. Système de fourniture d'horloge suivant l'une quelconque des revendications précédentes, caractérisé en ce que le générateur d'horloge fait partie d'un module (2) de circuit intégré à horloge à temps réel comportant en outre un moyen (2b) destiné à conserver des informations d'heure et/ou de date.

5. Système de fourniture d'horloge suivant l'une quelconque des revendications précédentes, caractérisé par le fait qu'une pluralité des synthétiseurs (11-16) de fréquence comportent chacun un ou plusieurs circuits à boucles à verrouillage de phase pour produire simultanément une ou plusieurs fréquences.

6. Système de fourniture d'horloge suivant la revendication 5, caractérisé par le fait que les synthétiseurs de fréquence ont en outre des moyens (37, 39, 40) de division pour diviser en fréquence le signal de sortie de l'oscillateur commandé en tension de chaque circuit (33-36) à boucle à verrouillage de phase et des bornes de commande pour commander les moyens de division de façon que des fréquences précisées soient délivrées en sortie au moyen d'un traitement électrique appliqué aux bornes de commande.

7. Système de fourniture d'horloge suivant la revendication 6, caractérisé en ce que le moyen (37, 39, 40) de division comprend un dispositif (39, 40) à mémoire, les fréquences précisées pouvant être obtenues par écriture de données dans le dispositif à mémoire au moyen d'un traitement électrique appliqué aux bornes de commande, et au moyen d'une commande de données utilisant les données écrites dans le dispositif à mémoire.

8. Système de fourniture d'horloge suivant la revendication 5, caractérisé en ce que le moyen de division comprend diverses combinaisons de connexions électriques à des bornes de commande externes.

9. Système de fourniture d'horloge suivant l'une quelconque des revendications précédentes, dans lequel le dispositif électronique est un ordinateur et les unités comprennent au moins l'une d'une unité (5) centrale de traitement, d'une unité (6) à disquette souple/disque dur, d'une unité (7) de commande de bus, d'une unité (8) de communication, d'une unité (9) d'affichage graphique VGA et d'une unité (10) à clavier, chacune comportant une unité à circuit intégré à semi-conducteur.

10. Système de fourniture d'horloge suivant la revendication 9, caractérisé en ce qu'au moins un signal d'horloge provenant d'au moins l'un des synthétiseurs (13a) de fréquence est fourni en commun à au moins deux des unités (5, 7).
